# EUROPÄISCHE PATENTSCHRIFT

(11) **EP 0 898 283 B1**
(45) Veröffentlichungstag und Bekanntmachung des Hinweises auf die Patenterteilung: **12.01.2005**
(21) Anmeldenummer: 98114095.7
(22) Anmeldetag: 28.07.1998
(51) Int. Cl.: G11C 29/00

(54) **Halbleiterbauelement und Verfahren zum Testen und Betreiben eines Halbleiterbauelementes**
Semiconductor component and method of testing and operating the semiconductor component
Composant à semi-conducteur et son procédé de test et opération

(30) Priorität: 14.08.1997 DE 19735406
(43) Veröffentlichungstag der Anmeldung: 24.02.1999
(73) Patentinhaber: Infineon Technologies AG, 81669 München (DE)
(72) Erfinder: Krause, Gunnar, 81541 München (DE)
(74) Vertreter: Kottmann, Heinz Dieter, Dipl.-Ing.

(56) Entgegenhaltungen:
- WO-A-97/25674
- US-A- 3 961 251

## Beschreibung

Die Erfindung betrifft ein Halbleiterbauelement und ein Verfahren zum Testen und Betreiben eines Halbleiterbauelementes, welches eine in bzw. auf einer Hauptoberfläche eines Halbleiterchips ausgebildete elektronische Schaltung, und auf der Hauptoberfläche des Halbleiterchips angeordnete, mit der elektronischen Schaltung elektrisch gekoppelte Anschlussflächen ("Pads") für die elektrische Kommunikation der Schaltung mit der Außenwelt aufweist, wobei die elektronische Schaltung zum einen in einem normalerweise im Waferverbund der Halbleiterchips durchzuführenden Testmodus, bei dem an einer vorbestimmten Anschlussfläche ein von außen zugeführtes Testsignal anliegt, und zum anderen in einem Betriebsmodus betreibbar ist, bei dem an den Anschlussflächen bzw. an mit den Anschlussflächen elektrisch gekoppelten, nach außerhalb des Bauelementes geführten Anschlussbeinchen Betriebssignale anliegen.

Ein synchroner dynamischer Halbleiterspeicher (SDRAM) als Beispiel eines solchen Halbleiterbauelementes ist beispielsweise aus Y. Takai et al., '250 Mbyte/s Synchronous DRAM Using a 3-Stage-Pipeline Architecture', IEEE Journal of Solid-State Circuits, Vol. 29, April 1994 pp. 526, Yuno Choy et al., '16-Mb Synchronous DRAM with 125-Mbyte/s Data Rate', IEEE Journal of Solid-State Circuits, Vol. 29, April 1994, pp. 529 bekannt geworden. Nach dem JEDEC-Standard Nr. 21-C werden derartige SDRAM-Halbleiterspeicher in sogenannten TSOP-2-Gehäuseformen mit typischerweise 50 äußeren Anschlussbeinchen (1 M x 16 SDRAM, 1 M x 18 SDRAM, 256 k x 16 SDRAM) oder 54 Anschlussbeinchen (16 M x 4 SDRAM, 8 M x 8 SDRAM, 4 M x 16 SDRAM) angeboten. Vornehmlich am Randbereich der Hauptoberfläche des Halbleiterchips sind metallische Anschlussflächen, sogenannten Pads ausgebildet, die der elektrischen Kommunikation der auf dem Halbleiterchip ausgebildeten Schaltungsbestandteile mit der Außenwelt dienen, und typischerweise eine quadratische Form mit Abmessungen von einigen µm x µm besitzen. Ein Teil dieser Anschlussflächen wird beispielsweise über Bonddrähte mit den nach außen ragenden Anschlussbeinchen beim Einbau in das Gehäuse des Halbleiterbauelementes verbunden. Ein geringerer Teil der Anschlussflächen ist nach dem Einbau des Halbleiterbauelementes in das Gehäuse von außen nicht mehr zugänglich; diese werden nur im Testmodus benötigt, bei dem sich die ungehäusten Halbleiterchips noch im Waferverbund befinden.

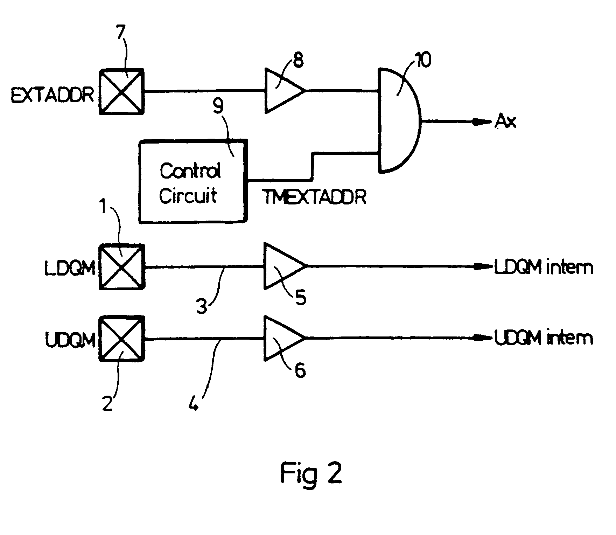

In Figur 2 sind die zur Erläuterung der Erfindung zugrunde liegenden Problemstellung erforderlichen Bestandteile eines herkömmlichen synchronen dynamischen Halbleiterspeichers SDRAM schematisch gezeigt. Dargestellt sind die den beiden DQM-Anschlüssen LDQM (Lower Input Mask/Output Enable) und UDQM (Upper Input Mask/Output Enable) des SDRAM zugeordneten Anschlussflächen 1 und 2, die als metallische, im Wesentlichen quadratisch gestaltete Pads auf der Hauptoberfläche des Halbleiterchips ausgebildet sind und elektrisch über Leitungen 3, 4 und Treiber 5, 6 mit der im Halbleiterchip angeordneten Steuer- und Logikschaltung verbunden ist, was in Figur 2 durch die Bezeichnungen LDQM intern und UDQM intern angedeutet ist. Weiterhin ist eine Testanschlussfläche 7 vorgesehen, welche zu Testzwecken benötigt wird, und an welche im Testmodus von außen ein Testaktivierungssignal EXTADDR angelegt wird. Die eigentlichen Testmodus-Sequenzen in der Form sogenannter IPL-Codes, die unter anderem dazu dienen, den noch im Waferverbund befindlichen, also noch ungehäusten Halbleiterspeicher hinsichtlich der Funktionsfähigkeit der redundanten und nicht-redundanten Bitleitungen bei geöffneter Wortleitung und dergleichen mehr zu testen, werden von einer Steuerschaltung 9 in Form eines Signales TMEXTADDR geliefert, welches an dem einen Eingang eines UND-Gatters 10 anliegt, an dessen Ausgang das zum Testen der relevanten Schaltungsteile dienendes Signal Ax ausgegeben wird. Der Testmodus wird durch das von außen an der Testanschlussfläche 7 anliegende Testaktivierungssignal EXTADDR aktiviert, welches über einen Treiber 8 an dem zweiten Eingang des UND-Gatters 10 liegt, und die Steuerschaltung 9 und damit die ausgegebenen Testmode-Sequenzen im Sinne eines Ein- und Ausschaltens steuert. Die auf der Hauptoberfläche des Halbleiterchips ausgebildete metallische Testanschlussfläche 7 ist damit lediglich zu Testzwecken erforderlich, und wird daran anschließend eigentlich nicht mehr benötigt.

Druckschrift US 3,961,251, welche die Oberbegriffe der unabhängigen Ansprüche offenbart, beschreibt eine Schaltungsanordnung zum Betrieb und zum Testen eines Speichers. Dabei werden Ein- und Ausgänge der Schaltung sowohl für den Test, als auch für den Betrieb der Schaltung verwendet.

Der Erfindung liegt daher die Aufgabe zugrunde, ein Halbleiterbauelement und insbesondere einen synchronen dynamischen Halbleiterspeicher vom wahlfreien Zugriffstyp bzw. ein Verfahren zum Testen und Betreiben eines solchen Halbleiterbauelementes zur Verfügung zu stellen, bei dem die lediglich zu Testzwecken benötigten, jedoch wertvolle Chipfläche beanspruchenden Testanschlussflächen eingespart werden können.

Diese Aufgabe wird vorrichtungsmäßig durch ein Halbleiterbauelement nach Anspruch 1 und verfahrensmäßig durch ein Verfahren nach Anspruch 7 gelöst.

Erfindungsgemäß ist wenigstens einer Anschlussfläche eine Schalteinrichtung zugeordnet, mit welcher die Funktion dieser Anschlussfläche vom Testmodus in den Betriebsmodus umschaltbar ist. Durch die Erfindung kann eine lediglich für Testzwecke benötigte Testanschlussfläche eingespart werden. Der für das Umschalten in den späteren Betriebsmodus der betroffenen Anschlussfläche benötigten Schalteinrichtung zusätzlich benötigte Platzbedarf auf der Hauptoberfläche des Halbleiterchips ist in aller Regel wesentlich geringer als der für eine Anschlussfläche, welche der makroskopisch zugänglichen Verbindung der Halbleiterschaltung mit der Außenwelt dient, benötigte Platz. Dies gilt selbst für eine vergleichsweise komplizierter aufgebaute Schalteinrichtung mit mehreren Transistoren. Die Schalteinrichtung kann am einfachsten fest verdrahtet auf der Hauptoberfläche des Halbleiterchips ausgebildet sein. Da die Schalteinrichtung in der Regel nur zu Testzwecken benötigt wird, ist hierbei des Weiteren vorgesehen, dass die Schalteinrichtung die damit gekoppelte Anschlussfläche irreversibel in den Betriebmodus schaltet. Zu diesem Zweck kann die Schalteinrichtung beispielsweise mit einem oder auch mehreren Fuses gekoppelt sein, die nach Durchführung sämtlicher Tests im Sinne einer Deaktivierung der Schalteinrichtung durchgebrannt werden.

Die Schalteinrichtung stellt bei einem schaltungstechnisch einfach zu realisierenden, daher bevorzugten Anwendungsfall eine Multiplex-Schaltung dar, bei der durch Anlegen eines vorzugsweise im Dualcode anliegenden Adresswortes jeweils einer von N Signaleingängen bzw. Eingangskanälen auf den Ausgang bzw. Ausgangskanal durchgeschaltet wird. Der Signalweg zwischen Ein- und Ausgang der Multiplex-Schaltung kann des weiteren durch ein Freigabesignal unterbrochen sein.

Bei einer besonders bevorzugten Ausführung der Erfindung ist die wenigstens eine, mit der Schalteinrichtung gekoppelte Anschlussfläche einem Datenein- bzw. -ausgang des Halbleiterbauelementes zugeordnet. Insbesondere handelt es sich bei dem Halbleiterbauelement um ein synchrones dynamisches Halbleiterspeicherbauelement vom wahlfreien Zugriffstyp (SDRAM), bei dem wenigstens eine der LDQM- oder UDQM-Anschlussflächen vermittels der Schalteinrichtung funktionsmäßig vom Testmodus in den Betriebsmodus umschaltbar ist. Im Besonderen stellt das Halbleiterbauelement ein SDRAM in x16-Konfiguration dar, bei dem zwei DQM-Anschlussflächen für je eine Gruppe von 8 Datenein- bzw. -ausgänge DQ0, DQ1, ... , DQ7 vorhanden sind. Im Testmodus wird vermittels der Schalteinrichtung beispielsweise die mit der Schalteinrichtung gekoppelte UDQM-Anschlussfläche zum DQM-Anschluss (Input Mask/Output Enable) für alle Datenein- bzw. -ausgänge DQs in den Testmodus umgeschaltet, und die gleichfalls mit der Schalteinrichtung gekoppelte LDQM-Anschlussfläche als Extended Address Bit geschaltet. Die Erfindung ermöglicht die Einsparung eines Charakterisierungspads bei voller Flexibilität hinsichtlich der Durchführung von allen bei einem SDRAM üblichen Testmode-Sequenzen.

Vorteilhafte Weiterbildungen der Erfindung ergeben sich aus den weiteren Unteransprüchen.

Nachfolgend wird die Erfindung anhand eines in der Zeichnung dargestellten Ausführungsbeispiels weiter erläutert. Im Einzelnen zeigen die Darstellungen in:
- Figur 1: eine ausschnittsweise Darstellung eines erfindungsgemäßen synchronen dynamischen Halbleiterspeichers SDRAM; und
- Figur 2: eine ausschnittsweise Darstellung eines herkömmlichen Halbleiterspeichers.

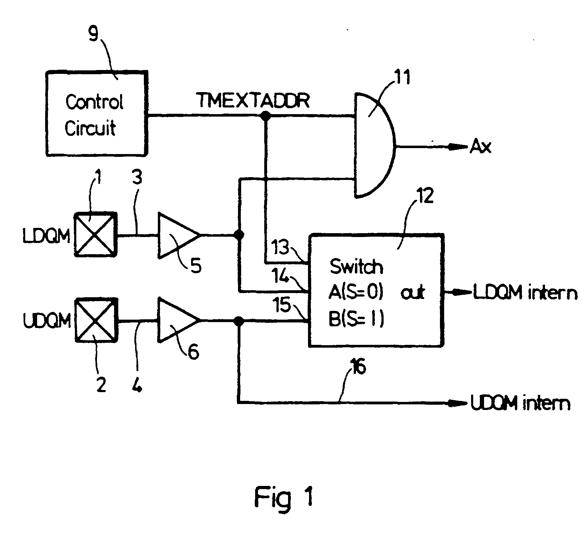

Bei dem in Figur 1 dargestellten Ausführungsbeispiel eines erfindungsgemäßen Halbleiterspeichers bezeichnen gleiche Bezugsziffern gleiche Komponenten wie bei der eingangs gemäß Figur 2 beschriebenen Schaltung, so dass deren Erläuterung nicht wiederholt wird. Im Unterschied zur Anordnung nach Figur 2 und entsprechend dem Wesen der Erfindung besitzt die Anordnung nach Figur 1 eine Schalteinrichtung 12 in Form einer 2:1-Multiplex-Schaltung mit einem Freigabeeingang 13, an welchem die von der Steuerschaltung 9 ausgegebenen Testsequenzen in Form des Signales TMEXTADDR anliegen (diese werden am Ausgang des UND-Gatters 11 als Signale Ax weitergeleitet), und deren Eingänge 14 und 15 mit LDQM bzw. UDQM beaufschlagt sind. Der Ausgang des Multiplexers 12 liefert das Signal LDQM intern, während das Signal UDQM intern über die Leitung 16 unmittelbar weitergeleitet wird. Die Schalteinrichtung 12 weist folgende Pegeltabelle auf, wobei die Ziffern die logischen Schaltungszustände NULL und EINS bezeichnen:

| **EINGANG** | | | **AUSGANG** | | |
|---|---|---|---|---|---|
| **TMEXTADDR** | **LDQM** | **UDQM** | **LDQM intern** | **UDQM intern** | **Ax** |
| 0 | 0 | 0 | 0 | 0 | 0 |
| 0 | 0 | 1 | 0 | 1 | 0 |
| 0 | 1 | 0 | 1 | 0 | 0 |
| 0 | 1 | 1 | 1 | 1 | 0 |
| 1 | 0 | 0 | 0 | 0 | 0 |
| 1 | 0 | 1 | 1 | 1 | 0 |
| 1 | 1 | 0 | 0 | 0 | 1 |
| 1 | 1 | 1 | 1 | 1 | 1 |

Das Signal Ax ist NULL im Falle einer Standardaktivierung bzw. Standardauswahl von nicht-redundanten und gefusten Elementen der Schaltung, und ist EINS im Falle der Aktivierung bzw. Auswahl von redundanten Elementen. Man erkennt weiterhin, dass das Signal UDQM im Testmodus zum Signal DQM für sämtliche Datenein- und -ausgangsanschlüsse DQ des Halbleiterspeichers wird, und das Signal LDQM in diesem Fall als Extended Address Bit geschaltet wird. Das Ausführungsbeispiel bezieht sich auf ein SDRAM in x 16-Konfiguration, bei dem die beiden DQM-Anschlussflächen 1 und 2 für je eine Gruppe von 8 DQ-Anschlüssen vorhanden sind. Die Erfindung ist jedoch auch für andere Konfigurationen, beispielsweise x 4-Konfiguration oder x 8-Konfiguration geeignet.

Die Erfindung ermöglicht eine voll flexible Testmöglichkeit von Speicherzellen einschließlich redundanter Wort- und Bitleitungen, ohne dass für die Information, ob ein redundantes oder nicht-redundantes Element adressiert werden soll, eine zusätzliche Testanschlussfläche erforderlich ist.

## Patentansprüche

1. Halbleiterbauelement mit einer in bzw. auf einer Hauptoberfläche eines Halbleiterchips ausgebildeten elektronischen Schaltung (9) und auf der Hauptoberfläche des Halbleiterchips angeordneten, mit der elektronischen Schaltung (9) elektrisch gekoppelten Anschlussflächen (Pads") (1, 2) für die elektrische Kommunikation der Schaltung (9) mit einer Außenwelt, wobei die elektronische Schaltung (9) zum einen in einem normalerweise im Waferverbund der Halbleiterchips durchzuführenden Testmodus, bei dem an einer vorbestimmten Anschlussfläche (1, 2) ein von außen zugeführtes Testsignal aus Testmodus-Sequenzen anliegt, und zum anderen in einem Betriebsmodus betreibbar ist, bei dem an den Anschlussflächen (1, 2) bzw. an mit den Anschlussflächen (1, 2) elektrisch gekoppelten, nach außerhalb des Bauelements geführten Anschlussbeinchen Betriebssignaleaus Datenein- und -ausgängen anliegen,
**dadurch gekennzeichnet,**
**dass** wenigstens einer Anschlussfläche (1, 2) eine Schalteinrichtung (12) zugeordnet ist, mit welcher diese Anschlussfläche (1, 2) irreversibel als Anschluss für das Testsignal in einen Anschluss für das Betriebssignal umschaltbar ist.

2. Halbleiterbauelement nach Anspruch 1,
**dadurch gekennzeichnet,**
**dass** die Schalteinrichtung (12) fest verdrahtet auf der Hauptoberfläche des Halbleiterchips ausgebildet ist.

3. Halbleiterbauelement nach Anspruch 1 oder 2,
**dadurch gekennzeichnet,**
**dass** die wenigstens eine, mit der Schalteinrichtung gekoppelte Anschlussfläche (1, 2) einem Datenein- bzw. - ausgang des Halbleiterbauelements zugeordnet ist.

4. Halbleiterbauelement nach einem der Ansprüche 1 bis 3,
**dadurch gekennzeichnet,**
**dass** die Schalteinrichtung durch ein von einer Steuerschaltung (9) stammendes Steuersignal (TMEXTADDR) geschaltet wird.

5. Halbleiterbauelement nach einem der Ansprüche 1 bis 4,
**dadurch gekennzeichnet,**
**dass** es sich um ein synchrones dynamisches Halbleiterspeicherbauelement vom wahlfreien Zugriffstyp (SDRAM) handelt, bei dem wenigstens eine der Loser Input Mask/Output Enable-(LDQM) oder Upper Input Mask/Output Enable-(UDQM) Anschlussflächen (1, 2) mittels der Schalteinrichtung (12) in einen Anschluss für einen Testmodus umschaltbar ist.

6. Halbleiterbauelement nach einem der Ansprüche 1 bis 4,
**dadurch gekennzeichnet,**
**dass** die mit der Schalteinrichtung gekoppelte Lower Input Mask/Output Enable-Anschlussfläche oder Upper Input Mask/Output Enable-Anschlussfläche (1, 2) im Testmodus als "Extended Address Bit" geschaltet ist.

7. Verfahren zum Testen und Betreiben eines Halbleiterbauelements, welches eine in bzw. auf einer Hauptoberfläche eines Halbleiterchips ausgebildete elektronische Schaltung (9), und auf der Hauptoberfläche des Halbleiterchips angeordnete, mit der elektronischen Schaltung (9) elektrisch gekoppelte Anschlussflächen ("Pads") (1, 2) für die elektrische Kommunikation der Schaltung (9) mit der Außenwelt aufweist, wobei die elektronische Schaltung (9) zum einen in einem normalerweise im Waferverbund der Halbleiterchips durchzuführenden Testmodus, bei dem an einer vorbestimmten Anschlussfläche (1, 2) ein von außen zugeführtes Testsignal aus Testmodus-Sequenzen anliegt, und zum anderen in einem Betriebsmodus betreibbar ist, bei dem an den Anschlussflächen (1, 2) bzw. an mit den Anschlussflächen (1, 2) elektrisch gekoppelten, nach außerhalb des Bauelements geführten Anschlussbeinchen Betriebssignale an Datenein- und ausgängen anliegen,
**dadurch gekennzeichnet,**
**dass** wenigstens einer Anschlussfläche (1, 2) eine Schalteinrichtung (12) zugeordnet wird, mit welcher diese Anschlussfläche (1, 2) irreversibel als Anschluss für das Testsignal in einen Anschluss für das Betriebssignal umgeschaltet wird.

8. Verfahren nach Anspruch 7,
**dadurch gekennzeichnet,**
**dass** die Schalteinrichtung fest verdrahtet auf der Hauptoberfläche des Halbleiterchips ausgebildet wird.

9. Verfahren nach Anspruch 7 oder 8,
**dadurch gekennzeichnet,**
**dass** die wenigstens eine, mit der Schalteinrichtung gekoppelte Anschlussfläche (1, 2) einem Datenein- bzw. -ausgang des Halbleiterbauelements zugeordnet wird.

10. Verfahren nach einem der Ansprüche 7 bis 9,
**dadurch gekennzeichnet,**
**dass** die Schalteinrichtung durch ein von einer Steuerschaltung (9) stammendes Steuersignal geschaltet wird.

11. Verfahren nach einem der Ansprüche 7 bis 10,
**dadurch gekennzeichnet,**
**dass** es sich um ein synchrones dynamisches Halbleiterspeicherbauelement vom wahlfreien Zugriffsytp (SDRAM) handelt, bei dem wenigstens eine der Lower Input Mask/Output Enable- oder Upper Input Mask/Output Enable-Anschlussflächen (1, 2) mittels der Schalteinrichtung in einen Anschluss für einen Testmodus umgeschaltet wird.

12. Verfahren nach einem der Ansprüche 7 bis 11,
**dadurch gekennzeichnet,**
**dass** die mit der Schalteinrichtung gekoppelte Lower Input Mask/Output Enable-Anschlussfläche oder Upper Input Mask/Output Enable-Anschlussfläche (1, 2) im Testmodus als "Extended Address Bit" geschaltet wird.

## Claims

1. Semiconductor component having an electronic circuit (9) which is formed in or on a main surface of a semiconductor chip, and having connecting surfaces ("pads") (1, 2), which are arranged on the main surface of the semiconductor chip and are electrically coupled to the electronic circuit (9), for electrical communication between the circuit (9) and an outside world, the electronic circuit (9) on the one hand being operable in a test mode, which can normally be carried out in the wafer composite of the semiconductor chips and in which an externally supplied test signal composed of test mode sequences is applied to a predetermined pad (1, 2), and on the other hand being operable in an operating mode in which operating signals composed of data inputs and outputs are applied to the pads (1, 2) and/or to connecting legs which are electrically coupled to the pads (1, 2) and are connected to the outside of the component,
**characterized in that**
at least one pad (1, 2) is assigned a switching device (12), by means of which it is possible to switch this pad (1, 2) from the test mode to the operating mode.

2. Semiconductor component s claimed in Claim 1,
**characterized in that**
the switching device (12) is designed to be hard-wired on the main surface of the semiconductor chip.

3. Semiconductor component as claimed in Claim 1 or 2,
**characterized in that**
the at least one pad (1, 2) which is coupled to the switching device is assigned to a data input or output of the semiconductor component.

4. Semiconductor component s claimed in one of Claims 1 to 3,
**characterized in that**
the switching device is switched by a control signal (TMEXTADDR) which originates from a control circuit (9).

5. Semiconductor component s claimed in one of Claims 1 to 4,
**characterized in that**
this semiconductor component is a synchronous, dynamic semiconductor memory component of the random access type (SDRAM), in which at least one of the Lower Input Mask/Output Enable (LDQM) or Upper Input Mask/Output Enable (UDQM) pads (1, 2) can be changed to a connection for a test mode by means of the switching device (12).

6. Semiconductor component s claimed in one of Claims 1 to 4,
**characterized in that**
the Lower Input Mask/Output Enable pad or Upper Input Mask/Output Enable pad (1, 2) which is coupled to the switching device is switched as an "Extended Address Bit" in the test mode.

7. Method for testing and operating a semiconductor component, which has an electronic circuit (9) which is formed in or on a main surface of a semiconductor chip, and has connecting surfaces ("pads") (1, 2), which are arranged on the main surface of the semiconductor chip and are electrically coupled to the electronic circuit (9), for electrical communication between the circuit (9) and the outside world, the electronic circuit (9) on the one hand being operable in a test mode, which can normally be carried' out in the wafer composite of the semiconductor chips and in which an externally supplied test signal composed of test mode sequences is applied to a predetermined pad (1, 2), and on the other hand being operable in an operating mode in which operating signals at data inputs and outputs are applied to the pads (1, 2) and/or to connecting legs which are electrically coupled to the pads (1, 2) and are connected to the outside of the component,
**characterized in that**
at least one pad (1, 2) is assigned a switching device (12), by means of which this pad (1, 2) is switched irreversibly as a connection for the test signal to a connection for the operating signal.

8. The method according to Claim 7,
**characterized in that**
the switching device is designed to be hard-wired on the main surface of the semiconductor chip.

9. The method according to Claim 7 or 8,
**characterized in that**
the at least one pad (1, 2) which is coupled to the switching device is assigned to a data input or output of the semiconductor component.

10. The method according to one of Claims 7 to 9,
**characterized in that**
the switching device is switched by a control signal which originates from a control circuit (9).

11. The method according to one of claims 7 to 10,
**characterized in that**
the semiconductor component is a synchronous, dynamic semiconductor memory component of the random access type (SDRAM), in which at least one of the Lower Input Mask/Output Enable or Upper Input Mask/Output Enable pads (1, 2) is changed to a connection for a test mode by means of the switching device.

12. The method according to one of Claims 7 to 11,
**characterized in that**
the Lower Input Mask/Out Enable pad or Upper Input Mask/Output Enable pad (1, 2) which is coupled to the switching device is switched as an "Extended Address Bit" in the test mode.

## Revendications

1. Composant à semi-conducteur qui comporte un circuit électronique (9) conçu dans ou sur une surface principale d'une puce à semi-conducteur et des surfaces de connexion ("pads") (1, 2) disposées sur la surface principale de la puce à semi-conducteur, couplées électriquement au circuit électronique (9) et destinées à la communication électrique du circuit (9) avec le monde extérieur, le circuit électronique (9) pouvant fonctionner d'une part dans un mode de test qui s'effectue normalement dans la tranche de silicium de la puce à semi-conducteur et dans lequel un signal de test amené de l'extérieur et composé de séquences de mode de test est appliqué à une surface de connexion (1, 2) prédéterminée et d'autre part dans un mode de fonctionnement dans lequel des signaux d'exploitation, composés d'entrées et de sorties de données, sont appliqués aux surfaces de connexion (1, 2) ou à des broches de connexion couplées électriquement aux surfaces de connexion (1, 2) et guidées vers l'extérieur du composant,
**caractérisé par le fait qu'**il est associé à au moins une surface de connexion (1, 2) un dispositif de commutation (12), par lequel cette surface de connexion (1, 2) est commutable de façon irréversible de connexion pour le signal de test en connexion pour le signal de fonctionnement.

2. Composant à semi-conducteur selon la revendication 1,
**caractérisé par le fait que** le dispositif de commutation (12) est conçu comme un câblage fixe sur la surface principale de la puce à semi-conducteur.

3. Composant à semi-conducteur selon la revendication 1 ou 2,
**caractérisé par le fait que** la surface de connexion (1, 2) - il y en a au moins une - couplée au dispositif de commutation est associée à une entrée ou sortie de données du composant à semi-conducteur.

4. Composant à semi-conducteur selon l'une des revendications 1 à 3,
**caractérisé par le fait que** le dispositif de commutation est branché par un signal de commande (TMEXTADDR) provenant d'un circuit de commande (9).

5. Composant à semi-conducteur selon l'une des revendications 1 à 4,
**caractérisé par le fait qu'**il s'agit d'un composant mémoire à semi-conducteur dynamique synchrone du type à accès aléatoire (SDRAM) dans lequel au moins l'une des surfaces de connexion (1, 2) Lower Input Mask / Output Enable (LDQM) ou Upper Input Mask / Output Enable (UDQM) est commutable au moyen du dispositif de commutation (12) en une connexion pour un mode de test.

6. Composant à semi-conducteur selon l'une des revendications 1 à 4,
**caractérisé par le fait que** la surface de connexion Lower Input Mask / Output Enable ou la surface de connexion Upper Input Mask / Output Enable (1, 2) couplée au dispositif de commutation est branchée dans le mode de test comme "Extended Address Bit".

7. Procédé pour tester et faire fonctionner un composant à semi-conducteur qui comporte un circuit électronique (9) conçu dans ou sur une surface principale d'une puce à semi-conducteur et des surfaces de connexion ("pads") (1, 2) disposées sur la surface principale de la puce à semi-conducteur, couplées électriquement au circuit électronique (9) et destinées à la communication électrique du circuit (9) avec le monde extérieur, le circuit électronique (9) pouvant fonctionner d'une part dans un mode de test, qui s'effectue normalement dans la tranche de silicium de la puce à semi-conducteur et dans lequel un signal de test amené de l'extérieur et composé de séquences de mode de test est appliqué à une surface de connexion (1, 2) prédéterminée et d'autre part dans un mode de fonctionnement, dans lequel des signaux d'exploitation composés d'entrées et de sorties de données sont appliqués aux surfaces de connexion (1, 2) ou à des broches de connexion couplées électriquement aux surfaces de connexion (1, 2) et guidées vers l'extérieur du composant,
**caractérisé par le fait qu'**on associe à au moins une surface de connexion (1, 2) un dispositif de commutation (12), par lequel cette surface de connexion (1, 2) est commutée de façon irréversible de connexion pour le signal de test en connexion pour le signal d'exploitation.

8. Procédé selon la revendication 7,
**caractérisé par le fait qu'**on conçoit le dispositif de commutation comme un câblage fixe sur la surface principale de la puce à semi-conducteur.

9. Procédé selon la revendication 7 ou 8,
**caractérisé par le fait qu'**on associe la surface de connexion (1, 2) - il y en a au moins une - couplée au dispositif de commutation à une entrée ou sortie de données du composant à semi-conducteur.

10. Procédé selon l'une des revendications 7 à 9,
**caractérisé par le fait que** le dispositif de commutation est branché par un signal de commande provenant d'un circuit de commande (9).

11. Procédé selon l'une des revendications 7 à 10,
**caractérisé par le fait qu'**il s'agit d'un composant mémoire à semi-conducteur dynamique synchrone du type à accès aléatoire (SDRAM) dans lequel au moins l'une des surfaces de connexion (1, 2) Lower Input Mask / Output Enable ou Upper Input Mask / Output Enable est commutée au moyen du dispositif de commutation en une connexion pour un mode de test.

12. Procédé selon l'une des revendications 7 à 11,
**caractérisé par le fait que** la surface de connexion Lower Input Mask / Output Enable ou la surface de connexion Upper Input Mask / Output Enable (1, 2) couplée au dispositif de commutation est branchée dans le mode de test comme "Extended Address Bit".
